# EUROPEAN PATENT SPECIFICATION

(11) **EP 0 696 007 B1**
(45) Date of publication and mention of the grant of the patent: **15.11.2000**
(21) Application number: 95305340.2
(22) Date of filing: 31.07.1995
(51) Int. Cl.: G06J 1/00, G11C 19/28, H03M 1/66

(54) **A multiplier utilising a charge transfer device**
Multiplizierer unter Verwendung einer Ladungsverschiebeanordnung
Multiplicateur utilisant un dispositif à transfert de charge

(30) Priority: 03.08.1994 JP 20025594
(43) Date of publication of application: 07.02.1996
(73) Proprietor: G.D.S. CO., LTD., Minato-ku, Tokyo (JP); Nagazumi, Yasuo, Meguro-ku, Tokyo 153 (JP)
(72) Inventor: Nagazumi, Yasuo, Meguro-ku, Tokyo 153 (JP)
(74) Representative: Gordon, Richard John Albert

(56) References cited:
- DE-A- 3 224 025
- US-A- 4 161 783
- US-A- 4 458 324
- US-A- 4 464 726
- US-A- 4 584 657
- US-A- 4 625 293

## Description

This invention relates to a multiplier utilising a charge transfer device which is broadly applicable to analog signal processing, D/A conversion or parallel image signal processing.

A variety of methods have been proposed and made practical as to multiplication processing between an analog signal and another signal, including multiplication type D/A conversion.

However, such methods are a "trade-off" between miniaturisation and accuracy deterioration inherent in analog signal processing and it has been argued that it is difficult to realise an integrated circuit of high density.

Moreover, when many resistors and capacitors are employed, it is presumed that a certain limit is imposed to the improvement of integration density and treatment of heat generated by the circuit.

In each of JP-A-5-43262, JP-A-6-154514 and JP-A-151544, each in the name of the inventor of the present invention, there is proposed apparatus wherein the division and the accumulation of an input signal in a charge domain is reiterated to realise a high accuracy D/A conversion with a simple circuit.

Multipliers using charge coupled devices are generally known, see for instance US-A-4 584 657 (TIEMANN et al) and US-A-4 458 324 (BURKE et al). Both references disclose serially connected stages of independently controllable potential wells.

The present invention is intended to provide a multiplier utilising a charge transfer device which realises particular advantages through a smaller circuit composition by further improving upon the inventions of the three applications referred to above.

The present invention is characterised in that there is provided at least eight independent potential wells arranged as a ring and charge signal accumulators having at least one set of a plurality of independently controlable potential wells connected in series to at least one of the potential wells of the ring.

Following is a description, by way of example only and with reference to the accompanying drawings, of one method of carrying the invention into effect.

In the drawings:-
Figure 1 is a composition diagram showing one example of the invention,
Figure 2 is a diagrammatic representation of a charge-couple device (CCD) embodying the composition of Figure 1,
Figure 3 is a diagram for indicating sequence procedure for performing a multiplication process according to one example of the invention,
Figure 4 is a composition diagram of another example of the invention,
Figure 5 is a composition diagram of another example of the invention,
Figure 6 is a composition diagram of another example of the invention,
Figure 7 is a composition diagram of another example of the invention, and
Figure 8 is a diagrammatic representation showing a circuit integrating twelve CCD multipliers of the type shown in Figure 2.

In the drawings, symbols P represent potential wells and hatched areas represent the arrangement of channel stops.

With each of the potential wells P, as is usual with CCDs, depth (potential level) is controlled by the potential applied from outside to a corresponding electrode and when a plurality of adjacent potential wells P are formed at the same time, a charge accumulated therein is held distributed over the whole of the wells P and when the intermediate wells P diminish, the charge is divided to potential wells P of both sides and held separately.

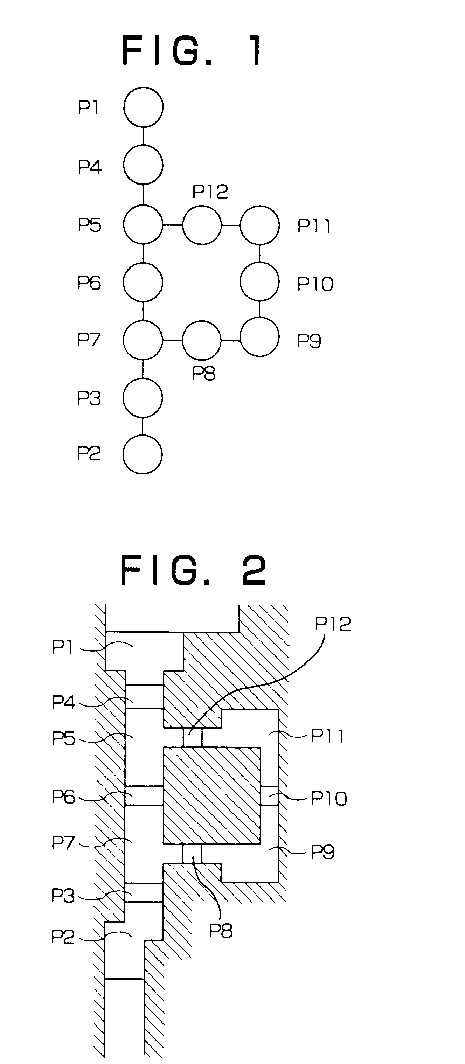

The situation is illustrated in Figure 1 in which potential wells P5, P6 and P7 comprise a charge splitter which divides an input charge into two charge packets through control of the intermediate potential well P6 and divides an initial charge held by the potential wells P5, P6 and P7 into two charge packets on the potential wells P5 and P7 of both sides.

This dividing operation is subjected to the effect of respective potential wells of an integrated circuit and, more particularly, the dividing accuracy is, in general, extremely insufficient when the circuit size is small.

Additional potential wells P8 to P12 comprising a ring are employed for improving the division accuracy by submitting this division result to further dividing and adding operations.

The mechanism of this precision improvement will not be described herein because it is explained in detail in JP-A-5-154514 and JP-A-6-151544 but almost one half of charges retained by the ring is output on the potential wells P5 and P7 and these charge signals are referred to as analog bit signals.

One of the two charge signals remains on the ring, the other one is sequentially added to either charge accumulator of potential wells P1 and P2 according to the bit value of digital signals supplied separately beginning with the most significant bit (MSB) and, as a result, charges on the ring are discharged outside the ring half by half each time when the processing of 1 bit is accomplished, so analog bit signals remaining on the ring and analog bit signals to be transferred to charge accumulators will decrease sequentially as Q/2, Q/4, Q/8 and so on taking the input charge quantity as Q.

When the conversion for all bits is completed, the result is accumulated in the two charge accumulators of potential wells P1 and P2 and the difference of their charge quantity will be a value corresponding to the two quadrant multiplication result.

In general, the potential distribution of a system composed of n potential wells may be determined uniquely, as shown hereinafter, by n dimension quantity of state vector V composed of state VPi of respective potential well.$\text{V = (vP1, vP3, vP4 ... vPn)}$

Here, if the process of sequential state vector variation from V1, V2, V3, Vj, ... is called "sequence SQ" and expressed by:$\text{SQ = (Vj) = (vPij)}$ the whole of the operation procedure of the system can be expressed in SQ assembly.

To simplify, the variable vPij used herein will be explained taking the example of binary digital data of 0 or 1 but it is essentially the same for multivalue data or analog value, so long as their mutual magnitude relation is maintained.

Additionally, in the following description, vPij = 0 means that the level of a potential well is shallow and vPij = 1 is deep, respectively.

Tables 1-1, 1-2, 1-3, 1-4, 1-5 and 1-6 shown hereinafter, represent six types of sequence operations for realising the function of a two quadrant multiplier with the composition shown in Figure 1.

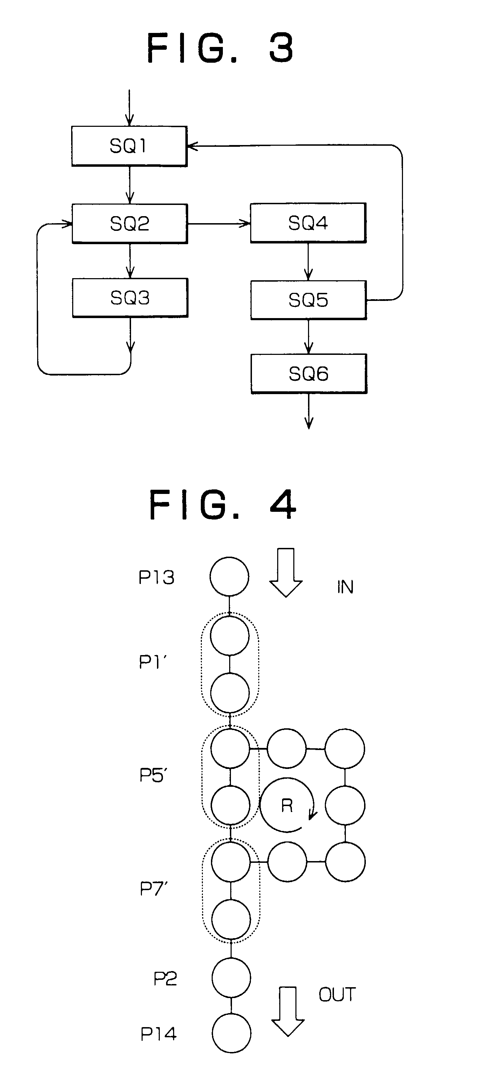

A charge signal input in potential wells (P5, P6, P7) at the beginning of the conversion will be eventually output as two charge signals of differential type accumulated in two potential wells P1 and P2 by applying the sequences SQ1 to SQ6 as shown in Figure 3 and by executing sequential multiplication from the most significant bit (MSB).

The procedure for executing the multiplication process will now be described with reference to Figure 3.

The sequence SQ1 shows the operation for roughly dividing the charge accumulated (in P5, P6, P7) into two equal parts. The resulting two charge packets are then divided by the processing of sequence SQ2 respectively into two equal parts for generating four charge packets that are added two by two at the end of SQ2 and put together into two charge packets.

The processing of the said sequence SQ2 having an effect of improving the accuracy of the operation to divide a charge into two equal parts, it is necessary to reiterate the execution for assuring a required accuracy level and the flow though the sequence SQ3 back to SQ2 illustrates this reiteration.

When the sequence SQ2 is reiterated for a predetermined number of times, two charge packets having the predetermined accuracy, designated as analog bit signal herein before defined, are held in potential wells P5, P11, P12 and P7, P8, P9 and, in the next sequence SQ4, these charge packets assemble in potential wells P5 and P7.

The sequence SQ5 executes D/A conversion or multiplication of 1 bit and selects two different processes according to the input digital signal value.

Therefore, when the digital bit is 1, the packet of the potential well P5 is added to P1 through the potential well P4 and when it is 0, the packet of the potential well P7 is added to P2 through the potential well P3.

The digital signals are the binary digits supplied by 1 bit starting from the most significant bit (MSB).

After completion of the sequence SQ5, if there are more bits to process, the processing is reiterated from the sequence SQ1 and when all bits are processed, the sequence SQ6 is executed before completing one multiplication process.

The processing of SQ6 is a step for discharging the charge corresponding to the less significant bit (LSB) remaining at last on the ring and is not related to the essence of the operation, so it may be omitted.

In consequence, a differential charge signal of the multiplication result is eventually output in the potential wells P1 and P2.

The composition supposes that potential wells P5, P6 and P7 are used as a charge splitter but, using different sequences, a set of different potential wells P7, P8 and P9 may be used as a charge splitter and, using the same composition as Figures 1 and 2, different application embodiments may be devised. The operation mode described herein, therefore, is for illustrative purposes only.

In the example shown in Figure 1 two charge signal accumulators comprising respectively potential wells P1, P4 and P2, P3 are connected to the ring comprising eight potential wells P5 to P12. However, if the charge signal accumulator of potential wells P2, P3 is removed from this composition and the adding operation from the potential well P7 on the ring to P2 is replaced by discard of a charge signal retained by potential well P7 the arrangement operates as one-quadrant multiplier, which is of simpler function.

Although, in Figure 1, two charge accumulators are connected to the potential wells P5, P7, the embodiment is illustrative of one example only, because the similar two quadrant multiplication may be executed by using a convenient sequence even when, for instance, the connection to the potential well P7 is replaced by the connection to the potential well P9.

Referring now to Figures 4, 5 and 6 there are shown examples of multipliers which combine data input/output channels, all of which are appropriate for performing the parallel operation by setting a number of multipliers in series.

In the example shown in Figure 4 potential wells P13 and P14 are included for input/output to the composition shown in Figure 1. A charge signal input IN is transferred through three-phase CCDs comprising potential wells P13, P1', P5', P7', P2 and P14 and the multiplication result accumulated in potential wells P1' and P14 is output OUT simultaneously with the transfer of input charge signal.

The potential wells P1', P5' and P7' shown in Figure 4 represent respectively coupled potential wells designated by potential wells P1, P4; P5, P6 and P7, P3 in Figure 1. It is apparent that, during input/output operations, each of these paired potential wells are controlled to act respectively as a single potential well. However, an irregular three-phase driving adopting a driving method wherein potential wells P4, P6, P3 are temporarily delayed in respect of potential wells P1, P5 and P7 respectively may be a more advantageous design choice because it is effective to decrease transfer loss.

In the embodiment shown in Figure 4, for starting the multiplication by performing input/output of the multiplier, data is shifted to the required location by executing the sequence of Table 2-1 shown hereinafter the required number of times and the sequence of Table 2-2 is executed once before passing to the operation shown in Figure 3.

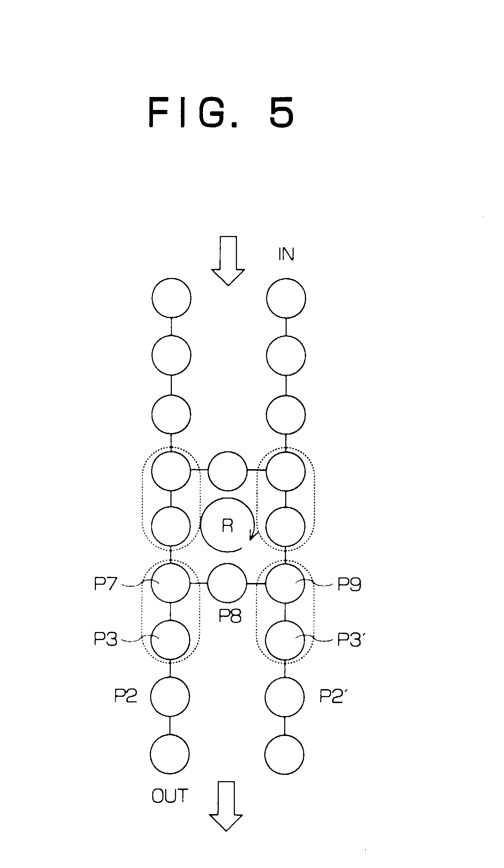

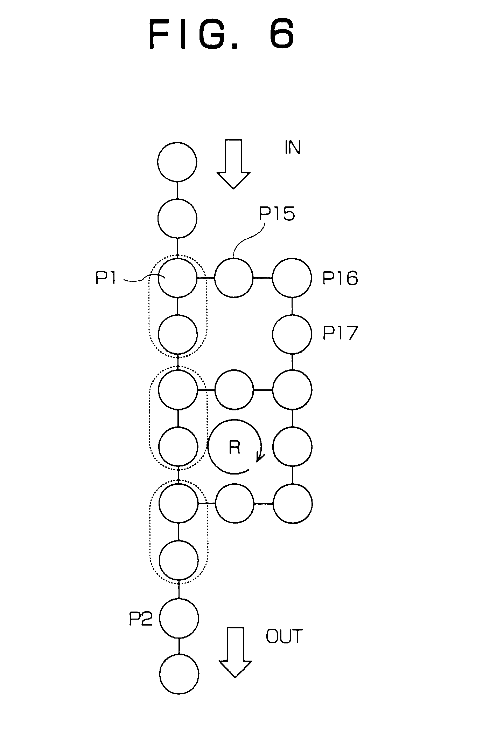

The examples shown in Figures 5 and 6 each comprise a four-quadrant multiplier embodying the composition shown in Figure 1.

In the example illustrated in Figure 5 two input/output CCDs similar to the example of Figure 4 are provided and positive/negative components of input and output signals, both taking the differential form, are supplied or discharged through the respective CCD. However, contrary to the example of Figure 1, the splitter of this embodiment is composed of potential wells P7, P8 and P9, while the charge signal accumulator is composed of potential wells P2, P3; P2', P3'.

In this system, differential signals supplied from IN are subjected to the multiplication processing consequently from either side and the result is assembled on the charge signal accumulator for the application requiring fast input/output given less stages of input/output CCD.

On the other hand, the example shown in Figure 6 provides for realisation of the four-quadrant multiplication by executing twice the two-quadrant multiplication processing shown in Figure 1 by means of simple addition of three potential wells P15, P16, P17 of the example shown in Figure 4.

The additional three potential wells are provided for maintaining one component of a differential input until the multiplication processing concerning the other component is accomplished. The arrangement is such that one of the differential charge input signals inputted from IN passes temporarily through the potential well P15 and is maintained in the potential well P16 and the other, as in the example of Figure 1, is multiplied by the two-quadrant multiplier on the ring R and the result is accumulated in the potential wells P1 and P2.

Subsequently, the charge signal maintained in the potential well P15 is supplied to the ring R through the potential well P17 and the two-quadrant multiplication is executed, the result also is additionally accumulated in the potential well P1 and P2, and eventually, when the two-quadrant multiplication of both input signals is completed, the result is accumulated in the potential wells P1 and P2. Such composition has an advantage for assuring smooth processing when differential signals with positive and negative components are alternatively supplied as input.

In the four-quadrant multiplication, as the processing of the positive component and the negative component of the input is opposed in respect of the polarity, the logical polarity of digital signals will be reversed; for instance, to multiply a digital value of (1010) in respect of the positive component, it is necessary to multiply the digital value of (0101), its complement, in respect of the negative component. Further details of such processing are disclosed in JP-A-5-43262.

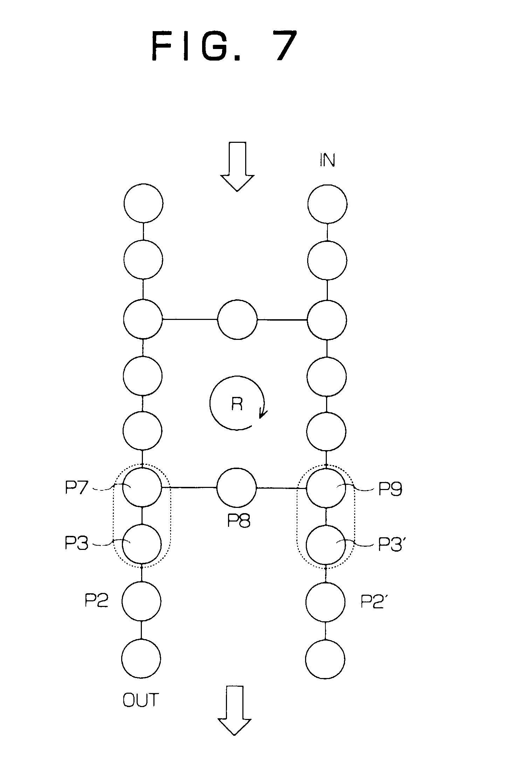

In Figure 7 there is shown an example wherein the ring R is composed as a three-phase CCD on the basis of the composition shown in Figure 5. In this composition, although the circuit is relatively more complex compared with the multiplier of the mode shown in Figure 1, it provides for faster execution of multiplication processing because data shift on the ring R is smoother than in the examples shown in Figures 4 to 6.

**Table 1-1.**

| Sequence of the primary division (SQ1) | | | | | | | | | | | | | |
|---|---|---|---|---|---|---|---|---|---|---|---|---|---|
| | P1 | P2 | P3 | P4 | P5 | P6 | P7 | P8 | P9 | P10 | P11 | P12 | |
| 1 | 1 | 1 | 0 | 0 | 1 | 1 | 1 | 0 | 0 | 0 | 0 | 0 | |
| 2 | 1 | 1 | 0 | 0 | 1 | 0 | 1 | 0 | 0 | 0 | 0 | 0 | DIVISION |
| 3 | 1 | 1 | 0 | 0 | 1 | 0 | 1 | 0 | 0 | 0 | 1 | 1 | |
| 4 | 1 | 1 | 0 | 0 | 0 | 0 | 1 | 0 | 0 | 0 | 1 | 1 | |
| 5 | 1 | 1 | 0 | 0 | 0 | 0 | 1 | 0 | 0 | 0 | 1 | 0 | |

**Table 1-2.**

| Sequence of the secondary division (SQ2) | | | | | | | | | | | | | |
|---|---|---|---|---|---|---|---|---|---|---|---|---|---|
| | P1 | P2 | P3 | P4 | P5 | P6 | P7 | P8 | P9 | P10 | P11 | P12 | |
| 1 | 1 | 1 | 0 | 0 | 1 | 1 | 1 | 0 | 1 | 1 | 1 | 0 | |
| 2 | 1 | 1 | 0 | 0 | 1 | 0 | 1 | 0 | 1 | 1 | 0 | 0 | DIVISION |
| 3 | 1 | 1 | 0 | 0 | 1 | 0 | 1 | 0 | 1 | 0 | 0 | 0 | |
| 4 | 1 | 1 | 0 | 0 | 1 | 0 | 1 | 0 | 1 | 0 | 1 | 1 | |
| 5 | 1 | 1 | 0 | 0 | 0 | 0 | 1 | 0 | 1 | 0 | 1 | 1 | |
| 6 | 1 | 1 | 0 | 0 | 0 | 0 | 1 | 0 | 1 | 0 | 1 | 0 | |
| 7 | 1 | 1 | 0 | 0 | 1 | 1 | 1 | 0 | 1 | 0 | 1 | 0 | |
| 8 | 1 | 1 | 0 | 0 | 1 | 1 | 0 | 0 | 1 | 0 | 1 | 0 | |
| 9 | 1 | 1 | 0 | 0 | 1 | 0 | 0 | 0 | 1 | 0 | 1 | 0 | |
| 10 | 1 | 1 | 0 | 0 | 1 | 0 | 1 | 1 | 1 | 0 | 1 | 0 | |
| 11 | 1 | 1 | 0 | 0 | 1 | 0 | 1 | 1 | 0 | 0 | 1 | 0 | |
| 12 | 1 | 1 | 0 | 0 | 1 | 0 | 1 | 0 | 0 | 0 | 1 | 0 | |
| 13 | 1 | 1 | 0 | 0 | 1 | 0 | 1 | 0 | 1 | 1 | 1 | 0 | |
| 14 | 1 | 1 | 0 | 0 | 1 | 0 | 1 | 0 | 1 | 1 | 0 | 0 | |
| 15 | 1 | 1 | 0 | 0 | 1 | 0 | 1 | 0 | 1 | 0 | 0 | 0 | |
| 16 | 1 | 1 | 0 | 0 | 1 | 0 | 1 | 0 | 1 | 0 | 1 | 1 | |
| 17 | 1 | 1 | 0 | 0 | 0 | 0 | 1 | 0 | 1 | 0 | 1 | 1 | |
| 18 | 1 | 0 | 1 | 0 | 1 | 1 | 1 | 0 | 1 | 0 | 1 | 0 | |
| 19 | 1 | 1 | 0 | 0 | 1 | 1 | 1 | 0 | 1 | 0 | 1 | 0 | |
| 20 | 1 | 1 | 0 | 0 | 1 | 0 | 1 | 0 | 1 | 0 | 1 | 0 | DIVISION |
| 21 | 1 | 1 | 0 | 0 | 1 | 0 | 1 | 1 | 1 | 0 | 1 | 0 | ADDITION |

**Table 1-3.**

| Sequence for the preparation of re-execution of the second division (SQ3) | | | | | | | | | | | | |
|---|---|---|---|---|---|---|---|---|---|---|---|---|
| | P1 | P2 | P3 | P4 | P5 | P6 | P7 | P8 | P9 | P10 | P11 | P12 |
| 1 | 1 | 1 | 0 | 0 | 0 | 0 | 1 | 1 | 0 | 0 | 1 | 1 |
| 2 | 1 | 1 | 0 | 0 | 0 | 0 | 1 | 0 | 0 | 0 | 1 | 0 |

**Table 1-4.**

| Sequence of division termination (SQ4) | | | | | | | | | | | | |
|---|---|---|---|---|---|---|---|---|---|---|---|---|
| | P1 | P2 | P3 | P4 | P5 | P6 | P7 | P8 | P9 | P10 | P11 | P12 |
| 1 | 1 | 1 | 0 | 0 | 1 | 0 | 1 | 1 | 0 | 0 | 0 | 1 |
| 2 | 1 | 1 | 0 | 0 | 1 | 0 | 1 | 0 | 0 | 0 | 0 | 0 |

**Table 1-5.**

| Sequence of one (1) bit D/A conversion (SQ5) | | | | | | | | | | | | |
|---|---|---|---|---|---|---|---|---|---|---|---|---|
| | P1 | P2 | P3 | P4 | P5 | P6 | P7 | P8 | P9 | P10 | P11 | P12 |
| | When digital input bit = 1 | | | | | | | | | | | |
| 1 | 1 | 1 | 1 | 0 | 1 | 0 | 1 | 0 | 0 | 0 | 0 | 0 |
| 2 | 1 | 1 | 1 | 0 | 1 | 0 | 0 | 0 | 0 | 0 | 0 | 0 |
| 3 | 1 | 1 | 0 | 0 | 1 | 0 | 0 | 0 | 0 | 0 | 0 | 0 |

| | When digital input bit = 0 | | | | | | | | | | | |
|---|---|---|---|---|---|---|---|---|---|---|---|---|
| 1' | 1 | 1 | 1 | 0 | 1 | 0 | 1 | 0 | 0 | 0 | 0 | 0 |
| 2' | 1 | 1 | 1 | 0 | 1 | 0 | 0 | 0 | 0 | 0 | 0 | 0 |
| 3' | 1 | 1 | 0 | 0 | 1 | 0 | 0 | 0 | 0 | 0 | 0 | 0 |

**Table 1-6.**

| Sequence of conversion completed (SQ6) | | | | | | | | | | | | |
|---|---|---|---|---|---|---|---|---|---|---|---|---|
| | P1 | P2 | P3 | P4 | P5 | P6 | P7 | P8 | P9 | P10 | P11 | P12 |
| 1 | 1 | 1 | 0 | 0 | 1 | 1 | 1 | 0 | 0 | 0 | 0 | 0 |
| 2 | 1 | 1 | 0 | 0 | 1 | 0 | 1 | 0 | 0 | 0 | 0 | 0 |
| 3 | 1 | 1 | 1 | 1 | 1 | 0 | 1 | 0 | 0 | 0 | 0 | 0 |
| 4 | 1 | 1 | 1 | 1 | 0 | 0 | 0 | 0 | 0 | 0 | 0 | 0 |
| 5 | 1 | 1 | 0 | 0 | 0 | 0 | 0 | 0 | 0 | 0 | 0 | 0 |

**Table 2-1.**

| Sequence of input/output mode (SQ21) | | | | | | | | | | | | | | |
|---|---|---|---|---|---|---|---|---|---|---|---|---|---|---|
| | P13 | P14 | P1 | P2 | P3 | P4 | P5 | P6 | P7 | P8 | P9 | P10 | P11 | P12 |
| 1 | 0 | 1 | 1 | 1 | 1 | 0 | 0 | 1 | 1 | 0 | 0 | 0 | 0 | 0 |
| 2 | 1 | 0 | 1 | 1 | 1 | 1 | 1 | 0 | 0 | 0 | 0 | 0 | 0 | 0 |
| 3 | 1 | 1 | 0 | 0 | 0 | 1 | 1 | 1 | 1 | 0 | 0 | 0 | 0 | 0 |

**Table 2-2.**

| Sequence of D/A conversion preparation (SQ22) | | | | | | | | | | | | | | |
|---|---|---|---|---|---|---|---|---|---|---|---|---|---|---|
| P13 | P14 | P1 | P2 | P3 | P4 | P5 | P6 | P7 | P8 | P9 | P10 | P11 | P12 | |
| 0 | 0 | 0 | 0 | 0 | 0 | 1 | 1 | 1 | 0 | 0 | 0 | 0 | 0 | INPUT COMPLETED |

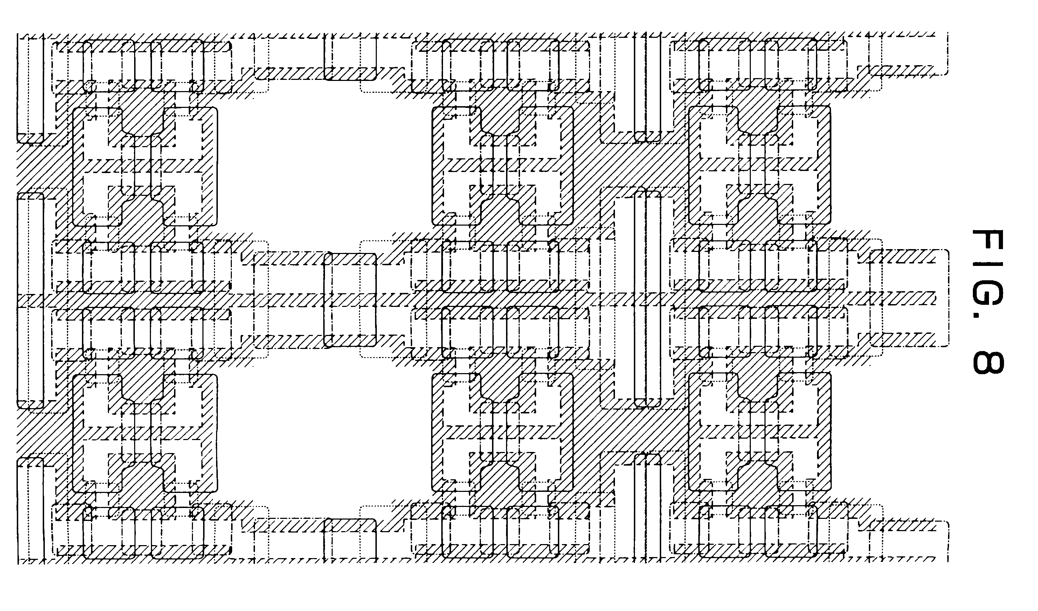

Referring now to Figure 8, there is shown a diagrammatic representation of twelve CCDs, each corresponding to Figure 2, which are combined in an integrated circuit.

In the Figure, hatched areas indicate channel stops and other shapes with corners represented by solid, broken or dashed lines indicate respectively the overlap electrodes of the first, second and third layers.

It will be appreciated from Figure 8 that the twelve multipliers provide a compact layout and the shift register for supplying the multipliers with input charge signals or for discharging their output signals may take a simple linear form.

## Claims

1. A multiplier utilising a charge transfer device comprising at least eight independent potential wells (P5 to P12) arranged as a ring and charge signal accumulators (P1,P4;P2,P3) having at least one set of a plurality of independently controlled potential wells connected in series to at least one of the potential wells (P5 to P12) of the ring.

2. A multiplier as claimed in Claim 1, wherein at least one set of potential wells of the potential wells (P5 to P12) arranged as the ring comprises three serial potential wells (P5, P6, P7) arranged as a charge splitter.

3. A multiplier as claimed in Claim 1, wherein a selective adding operation of an analog bit signal generated on the ring is performed by a selective charge transfer in response to an input digital bit signal from the potential wells (P5 to P12) constituting the ring with regard to at least one of said charge signal accumulator (P1, P4; P2, P3) connected in series with a corresponding potential well (P5, P7) of the ring.

4. A multiplier as claimed in Claim 1, wherein transfer of input/output charge signals is performed utilising at least a portion of the potential wells (P1 to P12) comprising the multiplier.

5. A multiplier as claimed in Claim 3, wherein there is provided two charge signal accumulator potential wells (P1,P4; P2,P3) connected in series with the ring wherein a selective data adding operation of an analog bit signal generated on the ring is performed to either of the charge signal accumulators (P1,P4; P2,P3) in response to an input digital signal from the potential wells (P5 to P12) comprising the ring.

6. A multiplier as claimed in Claim 5, wherein multiplication processing by an input digital signal and by its complementary binary signal is performed separately for each of a pair of charge signals comprising a differential signal.

## Patentansprüche

1. Multiplizierer unter Verwendung einer Ladungsverschiebeanordnung mit mindestens acht unabhängigen Potentialmulden (P5 bis P12), die ringförmig angeordnet sind, und mit Ladungssignalakkumulatoren (P1,P4;P2,P3), die mindestens ein Set einer Vielzahl unabhängig gesteuerter Potentialmulden aufweisen, die mit mindestens einer der Potentialmulden (P5 bis P12) des Ringes in Reihe geschaltet sind.

2. Multiplizierer nach Anspruch 1,
**dadurch gekennzeichnet**, daß
mindestens ein Set von Potentialmulden der als Ring angeordneten Potentialmulden (P5 bis P12) drei serielle Potentialmulden (P5,P6,P7) aufweist, die als Ladungsteiler angeordnet sind.

3. Multiplizierer nach Anspruch 1,
**dadurch gekennzeichnet**, daß
ein selektiver Hinzufügungsvorgang eines auf dem Ring erzeugten Analogbitsignals durch eine selektive Ladungsverschiebung als Reaktion auf ein von den Potentialmulden (P5 bis P12) kommendes Eingangsdigitalbitsignal ausgeführt wird, aus denen der Ring in bezug auf mindestens einen der Ladungssignalakkumulatoren (P1,P4;P2,P3) besteht, die mit einer entsprechenden Potentialmulde (P5, P7) des Ringes in Reihe verbunden sind.

4. Multiplizierer nach Anspruch 1,
**dadurch gekennzeichnet**, daß
eine Verschiebung der Eingangs-/Ausgangsladungssignale unter Verwendung mindestens eines Teils der Potentialmulden (P1 bis P12) erfolgt, aus denen der Multiplizierer besteht.

5. Multiplizierer nach Anspruch 3,
**dadurch gekennzeichnet**, daß
zwei mit dem Ring in Reihe geschaltete Ladungssignalakkumulator-Potentialmulden (P1,P4;P2,P3) vorgesehen sind, wobei ein selektive Daten hinzufügender Vorgang eines auf dem Ring erzeugten Analogbitsignals zu einem beliebigen der Ladungssignalakkumulatoren (P1,P4;P2,P3) als Reaktion auf ein von den Potentialmulden (P5 bis P12) kommendes Eingangsdigitalbitsignal geschickt wird, aus denen der Ring besteht.

6. Multiplizierer nach Anspruch 5,
**dadurch gekennzeichnet**, daß
die Multiplikationsverarbeitung durch ein Digitaleingangssignal und durch dessen ergänzendes Binärsignal separat für jedes Paar von Ladungssignalen besteht, das ein Differentialsignal umfaßt.

## Revendications

1. Multiplicateur utilisant un dispositif à transfert de charges comportant au moins huit puits de potentiel (P5 à P12) indépendants, agencés de manière à former un anneau, et des accumulateurs de signaux de charge (P1, P4, P2, P3) comportant au moins un ensemble composé d'une pluralité de puits de potentiel contrôlés d'une manière indépendante, reliés en série à au moins l'un des puits de potentiel (P5 à P12) de l'anneau.

2. Multiplicateur selon la revendication 1, dans lequel au moins un ensemble de puits de potentiel, parmi les puits de potentiel (P5 à P12) formant l'anneau, comprend trois puits de potentiel (P5, P6, P7) situés en série, agencés de manière à former un diviseur de charge.

3. Multiplicateur selon la revendication 1, dans lequel une opération d'addition sélective d'un signal de bit analogique généré sur l'anneau est effectuée par un transfert de charge sélectif en réponse à un signal de bit numérique d'entrée provenant des puits de potentiel (P5 à P12) formant l'anneau par rapport à au moins l'un desdits accumulateurs de signaux de charge (P1, P4 ; P2, P3) reliés en série à un puits de potentiel (P5, P7) correspondant de l'anneau.

4. Multiplicateur selon la revendication 1, dans lequel le transfert de signaux de charge d'entrée/sortie est effectué en utilisant au moins une partie des puits de potentiel (P1 à P12) constituant le multiplicateur.

5. Multiplicateur selon la revendication 3, dans lequel sont prévus deux puits de potentiel accumulateurs de signaux de charge (P1, P4 ; P2, P3) reliés en série à l'anneau, dans lequel une opération d'addition de données sélective d'un signal de bit analogique généré sur l'anneau est effectuée sur l'un ou l'autre des accumulateurs de signaux de charge (P1, P4 ; P2, P3) en réponse à un signal numérique d'entrée en provenance des puits de potentiel (P5 à P12) formant l'anneau.

6. Multiplicateur selon la revendication 5, dans lequel un traitement de multiplication par un signal numérique d'entrée et par son signal binaire complémentaire est effectué séparément pour chacun des signaux d'une paire de signaux de charge constituant un signal différentiel.
